# EUROPEAN PATENT SPECIFICATION

(11) **EP 4 280 271 B1**
(45) Date of publication and mention of the grant of the patent: **24.06.2026**
(21) Application number: 22173412.2
(22) Date of filing: 16.05.2022
(51) Int. Cl.: H01L 23/373

(54) **POWER SEMICONDUCTOR MODULE ARRANGEMENT AND METHOD FOR PRODUCING THE SAME**
LEISTUNGSHALBLEITERMODULANORDNUNG UND VERFAHREN ZUR HERSTELLUNG DAVON
AGENCEMENT DE MODULE SEMI-CONDUCTEUR DE PUISSANCE ET SON PROCÉDÉ DE FABRICATION

(43) Date of publication of application: 22.11.2023
(73) Proprietor: Infineon Technologies AG, 85579 Neubiberg (DE)
(72) Inventor: UNRAU, Arthur, 59590 Geseke (DE); DROSTE, Matthias, 59821 Arnsberg (DE); MÜCKE, Achim, 59597 Erwitte (DE)
(74) Representative: Westphal, Mussgnug & Partner, Patentanwälte mbB

(56) References cited:
- EP-A1- 3 499 649
- EP-A1- 3 937 226
- EP-A1- 3 955 288
- DE-A1- 102015 114 522
- US-A1- 2021 175 148
- US-A1- 2022 051 964
- US-B1- 6 762 491

## Description

### TECHNICAL FIELD

The instant disclosure relates to a power semiconductor module arrangement and to a method for producing the same.

### BACKGROUND

Document US 2022/051964 A1 discloses a baseplate for a semiconductor module comprising at least one elevation. The at least one elevation is formed integrally with the baseplate. The baseplate has a uniform first thickness or a thickness which decreases continuously from the edge regions toward the center and which is increased locally up to a maximum second thickness in the region of each of the at least one elevation

Document US 6 762 491 B1 discloses a power semiconductor device including a heat radiator having a principal surface and an insulating substrate bonded on the principal surface of the heat radiator via a first solder layer. The power semiconductor device also includes at least one semiconductor chip mounted on the insulating substrate via a second solder layer. The insulating substrate has a thin-layer and thick-layer edges, and is bonded on the principal surface of the heat radiator so that the first solder layer has a thickness thinner towards a direction from the thin-layer edge to the thick-layer edge. Also, the semiconductor chip is mounted on the insulating substrate so that a first distance between the thick-layer edge and the semiconductor chip is less than a second distance between the thin-layer edge and the semiconductor chip.

Document US 2021/175148 A1 discloses a semiconductor device, including a metal base plate having a front surface on which a disposition area is set apart from a central portion of the metal base plate, and a board placed over the disposition area with a solder therebetween. The solder has two edge portions of which one is closer than the other to the central portion of the metal base plate, said one being thicker than said the other.

Power semiconductor module arrangements often include a base plate within a housing. At least one substrate is arranged on the base plate. A semiconductor arrangement including a plurality of controllable semiconductor elements (e.g., two IGBTs in a half-bridge configuration) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The second metallization layer is usually attached to the base plate by means of a solder layer or a sintering layer. When mounting the at least one substrate to the base plate, e.g., by soldering or sintering techniques, the substrates and base plate are under the influence of high temperatures, wherein the temperatures usually lie at about 250°C or more, sometimes even at about 500°C and more. The at least one substrate, the connection layer (e.g., solder layer), and the base plate usually have different CTEs (coefficients of thermal expansion). When heating, and subsequently cooling the different components during the assembly process, the difference between the CTEs of the different materials (e.g., copper, ceramic, solder) leads to a deformation of the base plate, usually a concave deflection in the direction of the surface on which the substrates are mounted.

When mounting the base plate to a heat sink, a connection layer (e.g., thermal interface material) is arranged between the base plate and the heat sink. Such a connection layer usually completely fills the space between the base plate and the heat sink and therefore has a non-uniform thickness because of the deflection of the base plate. Therefore, base plates are often pre-bent to have a convex deflection in the direction of the surface on which the substrates are mounted. With such a pre-bent base plate, the heating, and subsequent cooling of the different components during the assembly process results in an essentially flat base plate. However, this may result in uneven thicknesses of the resulting connection layers arranged between the substrates and the base plate, depending on the severity of the base plate's initial bow and on the position of the substrates on the base plate. Uneven connection layers may negatively affect the performance and reliability of the power semiconductor module arrangement. There is a need for a power semiconductor module arrangement that avoids the drawbacks mentioned above as well as others and which has an increased performance and reliability, and for a method for producing such a power semiconductor module arrangement.

### SUMMARY

A power semiconductor module arrangement includes base plate, a plurality of substrates arranged on a first surface of the base plate, a plurality of connection layers, wherein each of the plurality of connection layers is arranged between a different one of the plurality of substrates and the base plate and permanently attaches the respective substrate to the base plate, and a plurality of spacers, wherein each of the plurality of spacers is arranged between a substrate and the base plate, and is embedded in the material of the respective connection layer, wherein for at least one of the plurality of substrates the following applies: no spacer is arranged below a first half of the respective substrate, and one or more spacers are arranged below a second half of the respective substrate. The first half and the second half of the respective substrate are defined by a plane that extends in the vertical direction and divides the substrate in two essentially similar halves.

A base plate for a power semiconductor module not falling under the scope of the claims includes a layer of a metallic material, and a plurality of spacers, the plurality of spacers comprising at least one of a first kind of spacers having a first height in a vertical direction perpendicular to a first surface of the layer of a metallic material, and at least one of a second kind of spacers having a second height in the vertical direction which is greater than the first height. The layer of metallic material has a convex deflection.

A method for forming a power semiconductor module arrangement includes arranging a plurality of substrates on a first surface of a base plate with a solid connection layer arranged between the base plate and each of the plurality of substrates, heating the base plate with the plurality of substrates and connection layers arranged thereon, thereby liquefying the material of the plurality of connection layers, and cooling the base plate with the plurality of substrates and connection layers arranged thereon, thereby solidifying the material of the plurality of connection layers, wherein for at least one of the plurality of substrates the following applies: no spacer is arranged below a first half of the respective substrate, and one or more spacers are arranged below a second half of the respective substrate. The first half and the second half of the respective substrate are defined by a plane that extends in the vertical direction and divides the substrate in two essentially similar halves, and each of the spacers is embedded in the material of the respective connection layer.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2, including Figures 2A - 2C, illustrates cross-sectional views of a substrate and base plate during different steps of the process of mounting the substrate on the base plate.
Figure 3 schematically illustrates a three-dimensional view of an exemplary pre-bent base plate.
Figure 4, including Figures 4A - 4C, schematically illustrates cross-sectional views of a base plate and a plurality of substrates during different steps of the process of mounting the substrates on the base plate.
Figure 5, including Figures 5A - 5C, schematically illustrates cross-sectional views of a base plate and a plurality of substrates according to one example during different steps of the process of mounting the substrates on the base plate.
Figure 6 schematically illustrates a cross-sectional view of a base plate and a plurality of substrates mounted on the base plate according to an even further example.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description as well as in the claims, designations of certain elements as "first element", "second element", "third element" etc. are not to be understood as enumerative. Instead, such designations serve solely to address different "elements". That is, e.g., the existence of a "third element" does not necessarily require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connectable pads and includes at least one semiconductor element with electrodes.

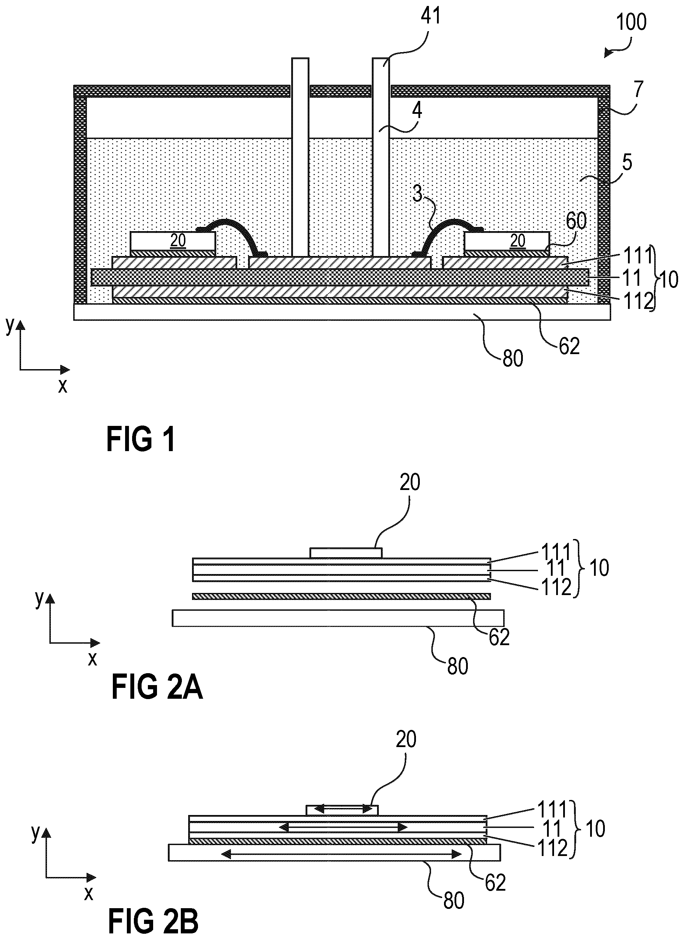

Referring to Figure 1, a cross-sectional view of a power semiconductor module arrangement 100 is illustrated. The power semiconductor module arrangement 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. Alternatively, the dielectric insulation layer 11 may consist of an organic compound and include one or more of the following materials: Al₂O₃, AlN, SiC, BeO, BN, or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AlN, SiN or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The substrate 10 may be arranged in a housing 7. In the example illustrated in Figure 1, the substrate 10 is arranged on a base plate 80 which forms a ground surface of the housing 7, while the housing 7 itself solely comprises sidewalls and a cover. In some power semiconductor module arrangements 100, more than one substrate 10 is arranged on the same base plate 80 and within the same housing 7. The base plate 80 may comprise a layer of a metallic material such as, e.g., copper or AlSiC. Other materials, however, are also possible.

One or more semiconductor bodies 20 may be arranged on the at least one substrate 10. Each of the semiconductor bodies 20 arranged on the at least one substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. According to another example, the second metallization layer 112 may be a structured layer. According to other examples, the second metallization layer 112 may be omitted altogether. The first metallization layer 111 is a structured layer in the example illustrated in Figure 1. "Structured layer" in this context means that the respective metallization layer is not a continuous layer, but includes recesses between different sections of the layer. Such recesses are schematically illustrated in Figure 1. The first metallization layer 111 in this example includes three different sections. Different semiconductor bodies 20 may be mounted to the same or to different sections of the first metallization layer 111. Different sections of the first metallization layer 111 may have no electrical connection or may be electrically connected to one or more other sections using electrical connections 3 such as, e.g., bonding wires. Semiconductor bodies 20 may be electrically connected to each other or to the first metallization layer 111 using electrical connections 3, for example. Electrical connections 3, instead of bonding wires, may also include bonding ribbons, connection plates or conductor rails, for example, to name just a few examples. The one or more semiconductor bodies 20 may be electrically and mechanically connected to the substrate 10 by an electrically conductive connection layer 60. Such an electrically conductive connection layer 60 may be a solder layer, a layer of an electrically conductive adhesive, or a layer of a sintered metal powder, e.g., a sintered silver (Ag) powder, for example.

The power semiconductor module arrangement 100 illustrated in Figure 1 further includes terminal elements 4. The terminal elements 4 are electrically connected to the first metallization layer 111 and provide an electrical connection between the inside and the outside of the housing 7. The terminal elements 4 may be electrically connected to the first metallization layer 111 with a first end, while a second end 41 of the terminal elements 4 protrudes out of the housing 7. The terminal elements 4 may be electrically contacted from the outside at their second end 41. Such terminal elements 4, however, are only an example. The components inside the housing 7 may be electrically contacted from outside the housing 7 in any other suitable way. For example, terminal elements 4 may be arranged closer to or adjacent to the sidewalls of the housing 7. It is also possible that terminal elements 4 protrude vertically or horizontally through the sidewalls of the housing 7. It is even possible that terminal elements 4 protrude through a ground surface of the housing 7. The first end of a terminal element 4 may be electrically and mechanically connected to the substrate 10 by an electrically conductive connection layer, for example (not explicitly illustrated in Figure 1). Such an electrically conductive connection layer may be a solder layer, a layer of an electrically conductive adhesive, or a layer of a sintered metal powder, e.g., a sintered silver (Ag) powder, for example. The first end of a terminal element 4 may also be electrically coupled to the substrate 10 via one or more electrical connections 3, for example.

The power semiconductor module arrangement 100 may further include an encapsulant 5. The encapsulant 5 may consist of or include a silicone gel or may be a rigid molding compound, for example. The encapsulant 5 may at least partly fill the interior of the housing 7, thereby covering the components and electrical connections that are arranged on the substrate 10. The terminal elements 4 may be partly embedded in the encapsulant 5. At least their second ends 41, however, are not covered by the encapsulant 5 and protrude from the encapsulant 5 through the housing 7 to the outside of the housing 7. The encapsulant 5 is configured to protect the components and electrical connections of the power semiconductor module 100, in particular the components arranged inside the housing 7, from certain environmental conditions and mechanical damage. It is generally also possible to omit the housing 7 and solely protect the substrate 10 and any components mounted thereon with an encapsulant 5. In this case, the encapsulant 5 may be a rigid material, for example.

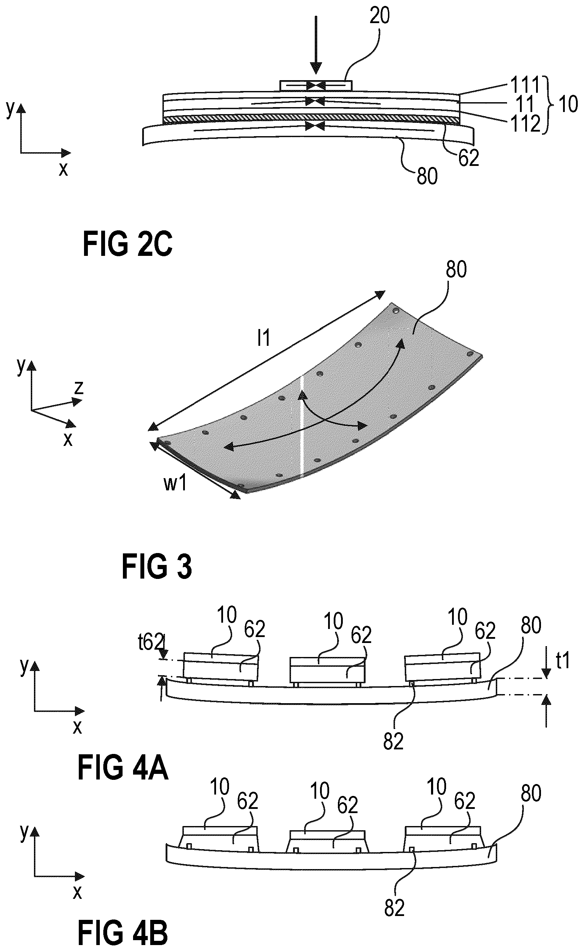

Now referring to Figure 2, a process of mounting a substrate 10 on a base plate 80 is schematically illustrated. The substrate 10 may be mechanically connected to the base plate 80 by a connection layer 62. That is, referring to Figure 2A, a connection layer 62 may be arranged between the substrate 10 and the base plate 80. The connection layer 62 that is applied between the substrate 10 and the base plate 80 may be a metallic solder layer or a sintered layer, for example. These, however, are only examples. The connection layer 62 may comprise any other suitable material that is suitable to form a mechanical connection between the substrate 10 and the base plate 80.

When the substrate 10 is mounted on the base plate 80 (at least one semiconductor body 20 may already be mounted on the substrate 10 at this stage), the substrate 10, connection layer 62, and base plate 80 are heated up to high temperatures, causing each of these components, which each comprise different materials, to expand according to their individual coefficients of thermal expansion (CTE). This is schematically illustrated in Figure 2B. During this process, the substrate 10 may be distorted. This is because the semiconductor body 20 and the substrate 10, which are rigidly bonded to one another, have different CTEs. Therefore, under the influence of high temperatures each of the components expands to a different extent, which is indicated with the different arrows in Figure 2B. The components (i.e., substrate 10, connection layer 62, and base plate 80) are subsequently cooled down again, which results in a contraction of the different materials (indicated with the different arrows in Figure 2C). The extent of the contraction also depends on the CTE of the materials. Therefore, after mounting a substrate 10 on an initially flat base plate 80, the base plate 80 often has a concave deflection in the direction of the surface on which the substrate 10 is mounted. This is schematically illustrated in Figure 2C. The base plate 80 may be deflected in one direction in space only. However, the base plate 80 may also be deflected in two directions in space, resulting in a cushion-shape or shell-like shape of the base plate 80. The deflection of the base plate 80 or, in other words, the deviation from its original (essentially plane/flat) form, may be, e.g., between about 20µm and about 2000µm or even more (the deviation corresponds to the difference in height between the edges and the center of the base plate 80). In order to compensate the resulting deflection, base plates 80 are often pre-bent (before mounting the substrate 10 on the base plate 80) in a direction opposite to the direction of the resulting deflection. An exemplary pre-bent base plate 80 is schematically illustrated in the three-dimensional view of Figure 3.

A cross-sectional view of a pre-bent base plate 80 is schematically illustrated in Figure 4A. In a power semiconductor module, one or more substrates 10 are often arranged on a single base plate 80. The base plate 80 may have a thickness t1 in the vertical direction y of between about 1mm and about 6mm, for example. The base plate 80, however, may also be thinner than 1mm or thicker than 6mm. The base plate 80 may comprise a layer consisting of or including a metal or a metal matrix composite material (e.g., metal matrix composite MMC such as aluminum silicon carbide), for example. Suitable materials for a metal base plate 80 are, for example, copper, a copper alloy, aluminum, or an aluminum alloy. The base plate 80 may be coated by a thin coating layer (not illustrated). Such a coating layer may consist of or include nickel, silver, gold, or palladium, for example. The coating layer is optional and may improve the solderability of the base plate 80. The base plate 80 may have a rectangular form and have a width w1 of between 2 and 5cm, and a length 11 of between 4 and 8cm, for example. Other shapes and dimensions, however, are also possible.

A plurality of substrates 10 that is mounted on a base plate 80 is exemplarily illustrated in Figure 4A. In particular, Figure 4A schematically illustrates the pre-bent base plate 80 before soldering the substrates 10 to the base plate 80. Usually, a connection layer 62 is attached to each of the substrates 10. The connection layers 62 at this point are generally solid and have a uniform thickness t62 in the vertical direction y. The substrates 10 with the connection layers 62 attached thereto are positioned at their desired positions on the base plate 80. Depending on their position on the base plate 80, the substrates 10 may be slightly beveled (see, e.g., left and right substrates 10 of Figure 4A) due to the deflection of the base plate 80. When the arrangement is subsequently heated, the connection layers 62 melt, which is schematically illustrated in Figure 4B. Lying on the melted connection layers 62, the substrates 10 generally orient themselves horizontally, as the upper surface of the liquid solder tends to a horizontal orientation due to gravity. This results in an uneven thickness of the connection layers 62 due to the deflection of the base plate 80. For a substrate 10 arranged close to an edge of the base plate 80, for example, due to the curvature of the base plate 80, the connection layer 62 may have a greater thickness towards the center of the base plate 80. This is schematically illustrated for the outermost substrates 10 in Figure 4B.

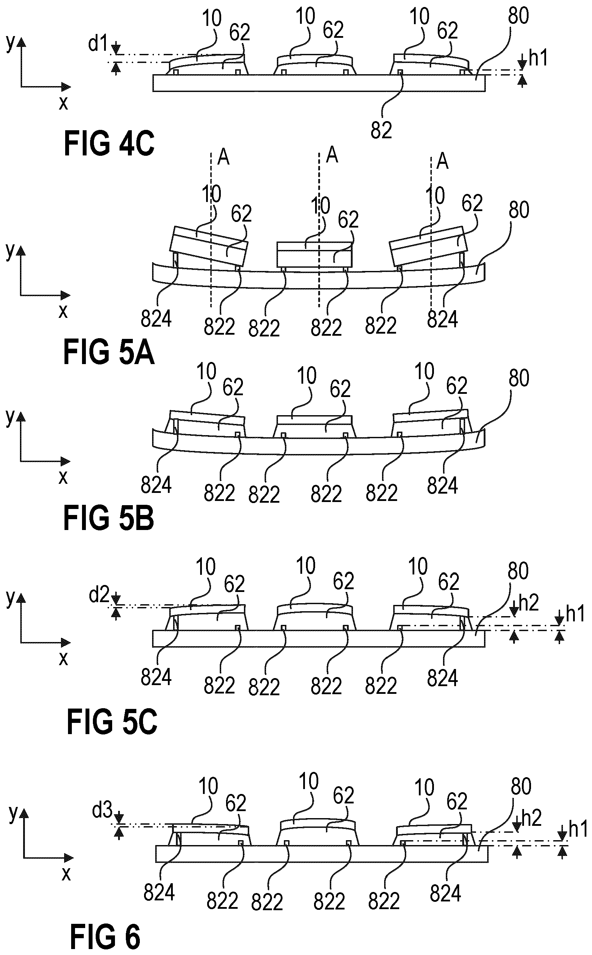

When the arrangement is subsequently cooled down again, due to the different CTEs of the different components, the base plate 80 deforms from its initially pre-bent form to an essentially flat form, similar to what has been described with respect to Figure 2C above. The connection layers 62 solidify (harden) and remain in their uneven form (connection layers 62 have a non-uniform thickness), resulting in a deflection of the substrates 10, as is schematically illustrated in Figure 4C. The uneven thickness of the connection layers 62 as well as the deflection of the substrates 10 may negatively affect the performance and reliability of the power semiconductor module arrangement.

In order to prevent the connection layers 62 of becoming too thin (less than a desired minimum thickness) during production, spacers 82 may be arranged between each of the substrates 10 and the base plate 80. Such spacers 82 are schematically illustrated in Figure 4. One or more spacers 82 may be arranged on the base plate 80, for example, before arranging the substrates 10 with the connection layers 62 thereon. The spacers 82 may be separate elements or may be integrally formed with the base plate 80. The spacers 82 may have any suitable form and may be arranged in any suitable positions on the base plate 80.

Usually, as few spacers 82 as possible are used, in order to save costs. According to one example, one spacer 82 is arranged below each corner of a rectangular semiconductor substrate 10. When joining the substrates 10 to the base plate 62 by means of the connection layers 62, the material forming the connection layers 62 is usually liquid or viscous during the heating step, as has been described above. The liquid or viscous material of the connection layers 62 may be displaced in the horizontal directions x, z to a certain degree and the thickness of the connection layers 62 may decrease, at least in some areas. The spacers 82 prevent the substrates 10 from moving closer to the base plate 80. However, due to the curvature of the base plate 80, it is possible that at least one side of a substrate 10 (e.g., a side which is closer to the center of the base plate 80) does not directly contact the respective spacers 82. This is, because a thickness of the resulting connection layer 62 may remain greater than a height h1 of the respective spacer 82. The spacers 82 may remain between the substrates 10 and the base plate 80 after mounting/joining the substrates 10 onto the base plate 80. The spacers 82 may have a rounded or a square cross-section, for example. Any other cross-sections, however, are also possible. According to one example, the spacers 82 have an elongated form. That is, a length of a spacer 82 in a second horizontal direction z may be significantly larger than a width of the spacer 82 in a first horizontal direction x perpendicular to the second horizontal direction x. For example, one spacer 82 may extend along at least 50%, at least 75%, or even at least 90% of the length l1 or width w1 of a substrate 10. The number of spacers 82 as well as their shape and dimensions may depend on the size and shape of the respective substrate 10, for example.

In a conventional power semiconductor module arrangement as has been described with respect to Figure 4 above, all of the spacers 82 have the same height h1 above the base plate 80. This height h1 is generally chosen to match the minimum desired thickness of the connection layer 62.

Now referring to the example illustrated in Figure 5, at least some of the spacers 82 have a greater height than others. That is, there may be at least two kinds of spacers 82. In the example illustrated in Figure 5 the arrangement comprises a first kind of spacers 822, having a first height h1 in the vertical direction y, and a second kind of spacers 824, having a second height h2 in the vertical direction y which is greater than the first height h1. According to one example, the second height h2 is between 20µm and 500µm greater than the first height h1.

As has been described above, at least some of a plurality of substrates 10 arranged on a base plate 80 may not even contact all of the respective spacers 82 after the heating step has been performed. As is schematically illustrated for the substrates 10 that are arranged closest to the edges of the base plate 80 where the curvature usually is more pronounced, such substrates 10 may not contact the spacers 822 that are arranged closer to a center of the base plate 80. That is, some of the spacers 822, due to the curvature of the base plate 80, may not be required at all, as the thickness of the connection layer 62 in the concerned areas is generally greater than the defined minimum thickness anyway. Therefore, it may also be possible to omit at least some of the first kind of spacers 822. Generally, the first height h1 of a spacer of the first kind 822, therefore, may be between 0 and 400µm, for example.

A second kind of spacers 824, which may be arranged closer to the edges of the base plate 80 has a second height h2 which is greater than the first height h1. The second height h2 of the second kind of spacers 824 may be chosen adequately in order to form a connection layer 62 having a more uniform thickness in the vertical direction y, as compared to the arrangement illustrated in Figure 4. In particular, the higher second kind of spacers 824 which are arranged closer to the edges of the base plate 80 prevent the respective substrates 10 from moving closer to the base plate 80. Therefore, while the material of the connection layers 62 is fluid during the heating step, the orientation of the respective substrates 10 may not be flat in a horizontal direction, but slightly beveled instead. This is schematically illustrated in Figure 5B. When the arrangement is subsequently cooled down, the base plate 80 bends out of its initially curved shape to an essentially flat shape, resulting in an essentially flat orientation of the substrates 10. This is schematically illustrated in Figure 5C.

The higher second kind of spacers 824 prevent one side of the respective substrates 10 to move closer to the base plate 80 than the other side of the substrate 10 with the first kind of spacers 822 arranged below.

Usually, at least one spacer 82 is arranged below a first half of a substrate 10, and at least one spacer 82 is arranged below a second half of the respective substrate 10. The first half and the second half of a substrate 10 may be defined by a plane A which divides the substrate 10 in two essentially similar halves, as is schematically illustrated in Figure 5A. According to one example, for at least one substrate 10 of a power semiconductor module arrangement (left and right substrates 10 in the example of Figure 5), one or more spacers 822 of the first kind are arranged below a first half of a substrate 10 (between the first half of the substrate 10 and the base plate 80), and one or more spacers 824 of the second kind are arranged below a second half of the same substrate 10 (between the second half of the substrate 10 and the base plate 80), wherein the first half of the substrate 10 is arranged closer to the center of the base plate 80 as compared to the second half which is arranged closer to an edge of the base plate 80. The height h2 of the one or more second kind of spacers 824 may depend on their position with regard to the plane A. That is, if the one or more second kind of spacers 824 are arranged closer to the plane A (closer to the center of the substrate 10), their height h2 may be chosen to be greater. If the one or more second kind of spacers 824 are arranged further away from the plane A (closer to the edge of the substrate 10), their height h2 may be chosen to be somewhat smaller. In any case, however, the height h2 of the one or more second kind of spacers 824 is greater than the height h1 of the one or more first kind of spacers 822. As has been described above, it is also possible to omit the first kind of spacers 822 for at least one of the substrates 10. In accordance with the invention, no spacer at all is arranged below the first half of the respective substrate 10, while one or more of the second kind of spacers 824 are arranged below the second half of the respective substrate 10.

If an uneven number of substrates 10 is arranged on a base plate 80, for example, there may be one substrate 10 which is arranged essentially at the center of the base plate 80 (middle substrate 10 in the example of Figure 5). Only spacers 822 of the first kind and no spacers 824 of the second kind may be arranged below such substrates 10, as is schematically illustrated for the middle substrate 10 in Figure 5. This is because such substrates 10 are generally not prone to the problems described with respect to Figure 4 above, because the curvature of the base plate 80 below the first half of the respective substrate 10 is generally symmetric to the curvature below the second half of the respective substrate 10.

By choosing the height h2 of the one or more second kind of spacers 824 it is possible to adjust the resulting orientation of the respective substrates 10. If, for example, the second height h2 is 200µm and the first height h1 is at least 20µm less than the second height h2, this may result in a still slightly beveled substrate 10, as is schematically illustrated in Figure 5C. In particular, the first half of the substrate 10, after cooling down the arrangement, may be slightly higher above the first surface of the base plate 80 as compared to the second half. A difference in height d2 between the two outermost edges of the respective substrate 10 may be between 50 and 100µm, for example. This difference in height d2 is significantly reduced as compared to the difference in height d1 resulting in the arrangement of Figure 4 (see Figure 4C). A tilt, however, still remains. If the second height h2 is increased further to, e.g., 250µm, the resulting difference in height d2 may be essentially zero. By increasing the second height h2 even further, e.g., to 300µm or more, this may result in a tilt in the other direction. That is, the second half of the substrate 10, after cooling down the arrangement, may be slightly higher above the first surface of the base plate 80 as compared to the first half. This may result in a difference in height d3 between the two outermost edges of the respective substrate 10 of between -50 and -150µm, for example (negative tilt values due to the different direction of the tilt). This is schematically illustrated in Figure 6. The values of the second height h2 of 200µm, 250µm and 300µm are merely examples. The specific values and the resulting differences in height dx depend on the dimensions and positions of the substrates 10 as well as on the dimensions and curvature of the base plate 80.

## Claims

1. A power semiconductor module arrangement comprising:
a base plate (80);
a plurality of substrates (10) arranged on a first surface of the base plate (80);
a plurality of connection layers (62), wherein each of the plurality of connection layers (62) is arranged between a different one of the plurality of substrates (10) and the base plate (80) and permanently attaches the respective substrate (10) to the base plate (80); and
a plurality of spacers (82, 824), wherein each of the plurality of spacers (82) is arranged between one substrate (10) of the plurality of substrates (10) and the base plate (80), and is embedded in the material of the respective connection layer (62),
wherein for at least one of the plurality of substrates (10) the following applies:
no spacer is arranged below a first half of the respective substrate (10), and one or more spacers (824) are arranged below a second half of the respective substrate (10),
wherein the first half and the second half of the respective substrate (10) are defined by a plane (A) that extends in the vertical direction (y) and divides the substrate (10) in two essentially similar halves.

2. The power semiconductor module arrangement of claim 1, wherein each of the one or more spacers (824) has a height (h2) of between 20µm and 900µm.

3. The power semiconductor module arrangement of any of claims 1 to 2, wherein the second half of the respective substrate (10) is arranged closer to an edge of the base plate (80) than its first half.

4. The power semiconductor module arrangement of any of claims 1 to 3, wherein the base plate (80) is flat.

5. The power semiconductor module arrangement of any of claims 1 to 4, wherein the base plate (80) comprises a layer of metallic material.

6. The power semiconductor module arrangement of any of claims 1 to 5, further comprising at least one semiconductor body (20) arranged on a top surface of each of the plurality of substrates (10), wherein the top surface of a substrate (10) is a surface facing away from the base plate (80).

7. The power semiconductor module arrangement of any of claims 1 to 6, wherein the plurality of connection layers (62) are solder layers.

8. A method for forming a power semiconductor module arrangement, the method comprising:
arranging a plurality of substrates (10) on a first surface of a base plate (80) with a solid connection layer (62) arranged between the base plate (80) and each of the plurality of substrates (10);
heating the base plate (80) with the plurality of substrates (10) and connection layers (62) arranged thereon, thereby liquefying the material of the plurality of connection layers (62); and
cooling the base plate (80) with the plurality of substrates (10) and connection layers (62) arranged thereon, thereby solidifying the material of the plurality of connection layers (62),
wherein for at least one of the plurality of substrates (10) the following applies:
no spacer is arranged below a first half of the respective substrate (10), and one or more spacers (824) are arranged below a second half of the respective substrate (10),
wherein the first half and the second half of the respective substrate (10) are defined by a plane (A) that extends in the vertical direction (y) and divides the substrate (10) in two essentially similar halves, and
wherein each of the one or more spacers (824) is embedded in the material of the respective connection layer (62).

9. The method of claim 8, wherein,
before heating the base plate (80) with the plurality of substrates (10) and connection layers (62) arranged thereon, the base plate (80) has a convex deflection, and
during the step of cooling the base plate (80) with the plurality of substrates (10) and connection layers (62) arranged thereon, the base plate (80) deforms from its convex form to a flat form.

## Patentansprüche

1. Leistungshalbleitermodulanordnung, umfassend:
eine Basisplatte (80);
eine Mehrzahl von Substraten (10), die auf einer ersten Oberfläche der Basisplatte (80) angeordnet ist;
eine Mehrzahl von Verbindungsschichten (62), wobei jede der Mehrzahl von Verbindungsschichten (62) zwischen einem anderen der Mehrzahl von Substraten (10) und der Bodenplatte (80) angeordnet ist und das jeweilige Substrat (10) dauerhaft an der Basisplatte (80) befestigt; und
eine Mehrzahl von Abstandshaltern (82, 824), wobei jeder der Mehrzahl von Abstandshaltern (82) zwischen einem Substrat (10) der Mehrzahl von Substraten (10) und der Basisplatte (80) angeordnet und in das Material der jeweiligen Verbindungsschicht (62) eingebettet ist,
wobei für mindestens eines der Mehrzahl von Substraten (10) Folgendes gilt:
es ist kein Abstandshalter unterhalb einer ersten Hälfte des jeweiligen Substrats (10) angeordnet und es sind ein oder mehrere Abstandshalter (824) unterhalb einer zweiten Hälfte des jeweiligen Substrats (10) angeordnet,
wobei die erste Hälfte und die zweite Hälfte des jeweiligen Substrats (10) durch eine Ebene (A) definiert sind, die sich in der vertikalen Richtung (y) erstreckt und das Substrat (10) in zwei im Wesentlichen ähnliche Hälften teilt.

2. Leistungshalbleitermodulanordnung nach Anspruch 1, wobei jeder des einen oder der mehreren Abstandshalter (824) eine Höhe (h2) zwischen 20 µm und 900 µm aufweist.

3. Leistungshalbleitermodulanordnung nach einem der Ansprüche 1 bis 2, wobei die zweite Hälfte des jeweiligen Substrats (10) näher an einem Rand der Basisplatte (80) als seine erste Hälfte angeordnet ist.

4. Leistungshalbleitermodulanordnung nach einem der Ansprüche 1 bis 3, wobei die Basisplatte (80) flach ist.

5. Leistungshalbleitermodulanordnung nach einem der Ansprüche 1 bis 4, wobei die Basisplatte (80) eine Schicht aus metallischem Material umfasst.

6. Leistungshalbleitermodulanordnung nach einem der Ansprüche 1 bis 5, ferner umfassend mindestens einen Halbleiterbody (20), der auf einer oberen Oberfläche jedes der Mehrzahl von Substraten (10) angeordnet ist, wobei die obere Oberfläche eines Substrats (10) eine Oberfläche ist, die von der Basisplatte (80) abgewandt ist.

7. Leistungshalbleitermodulanordnung nach einem der Ansprüche 1 bis 6, wobei es sich bei der Mehrzahl von Verbindungsschichten (62) um Lotschichten handelt.

8. Verfahren zur Bildung einer Halbeitermodulanordnung, wobei das Verfahren Folgendes umfasst:
Anordnen einer Mehrzahl von Substraten (10) auf einer ersten Oberfläche einer Basisplatte (80) mit einer festen Verbindungsschicht (62), die zwischen der Basisplatte (80) und jedem der Mehrzahl von Substraten (10) angeordnet wird;
Erwärmen der Basisplatte (80) mit der darauf angeordneten Mehrzahl von Substraten (10) und Verbindungsschichten (62), wodurch das Material der Mehrzahl von Verbindungsschichten (62) verflüssigt wird; und
Abkühlen der Basisplatte (80) mit der darauf angeordneten Mehrzahl von Substraten (10) und Verbindungsschichten (62), wodurch das Material der Mehrzahl von Verbindungsschichten (62) verfestigt wird,
wobei für mindestens eines der Mehrzahl von Substraten (10) Folgendes gilt:
es ist kein Abstandshalter unterhalb einer ersten Hälfte des jeweiligen Substrats (10) angeordnet und es sind ein oder mehrere Abstandshalter (824) unterhalb einer zweiten Hälfte des jeweiligen Substrats (10) angeordnet,
wobei die erste Hälfte und die zweite Hälfte des jeweiligen Substrats (10) durch eine Ebene (A) definiert sind, die sich in der vertikalen Richtung (y) erstreckt und das Substrat (10) in zwei im Wesentlichen ähnliche Hälften teilt; und
wobei jeder des einen oder der mehreren Abstandshalter (824) in das Material der jeweiligen Verbindungsschicht (62) eingebettet ist.

9. Verfahren nach Anspruch 8, wobei
die Basisplatte (80) vor dem Erwärmen der Basisplatte (80) mit der darauf angeordneten Mehrzahl von Substraten (10) und Verbindungsschichten (62) eine konvexe Durchbiegung aufweist, und
die Basisplatte (80) sich während des Schrittes des Abkühlens der Basisplatte (80) mit der darauf angeordneten Mehrzahl von Substraten (10) und Verbindungsschichten (62) aus ihrer konvexen Form in eine flache Form verformt.

## Revendications

1. Un agencement de module de semiconducteur de puissance comprenant :
une plaque (80) de base ;
une pluralité de substrats (10) disposés sur une première surface de la plaque (80) de base ;
une pluralité de couches (62) de connexion, dans lequel chacune de la pluralité de couches (62) de connexion est disposée entre un différent de la pluralité de substrats (10) et la plaque (80) de base et rattache de manière permanente le substrat (10) respectif à la plaque (80) de base ; et
une pluralité d'intercalaires (82, 824), dans lequel chacun de la pluralité d'intercalaires (82) est disposé entre un substrat (10) de la pluralité de substrats (10) et la plaque (80) de base et est noyé dans le matériau de la couche (62) respective de connexion,
dans lequel, pour au moins l'un de la pluralité de substrats (10), s'applique ce qui suit :
aucun intercalaire n'est disposé en dessous d'une première moitié du substrat (10) respectif et un ou plusieurs intercalaires (824) sont disposés en dessous d'une deuxième moitié du substrat (10) respectif,
dans lequel la première moitié et la deuxième moitié du substrat (10) respectif, sont définies par un plan (A), qui s'étend dans la direction (y) verticale et divise le substrat (10) en deux moitiés essentiellement semblables.

2. L'agencement de module de semiconducteur de puissance de la revendication 1, dans lequel chacun du un ou des plusieurs intercalaires (824) a une hauteur (h2) comprise entre 20 µm et 900 µm.

3. L'agencement de module de semiconducteur de puissance de l'une quelconque des revendications 1 à 2, dans lequel la deuxième moitié du substrat (10) respectif est disposée plus près d'un bord de la plaque (80) de base que sa première moitié.

4. L'agencement de module de semiconducteur de puissance de l'une quelconque des revendications 1 à 3, dans lequel la plaque (80) de base est plate.

5. L'agencement de module de semiconducteur de puissance de l'une quelconque des revendications 1 à 4, dans lequel la plaque (80) de base comprend une couche de matériau métallique.

6. L'agencement de module de semiconducteur de puissance de l'une quelconque des revendications 1 à 5, comprenant en outre, au moins un corps (20) à semiconducteur disposé sur une surface de sommet de chacun de la pluralité de substrats (10), dans lequel la surface de sommet d'un substrat (10) est une surface faisant face à la plaque (80) de base en en étant loin.

7. L'agencement de module de semiconducteur de puissance de l'une quelconque des revendications 1 à 6, dans lequel la pluralité de couches (62) de connexion sont des couches de brasure.

8. Un procédé pour former un agencement de module de semiconducteur de puissance, le procédé comprenant :
mettre une pluralité de substrats (10) sur une première surface d'une plaque (80) de base avec une couche (62) solide de connexion disposée entre la plaque (80) de base et chacun de la pluralité de substrats (10) ;
chauffer la plaque (80) de base avec la pluralité de substrats (10) et les couches (62) de connexion, qui y sont disposées, en liquéfiant ainsi le matériau de la pluralité de couches (62) de connexion ; et
refroidir la plaque (80) de base avec la pluralité de substrats (10) et les couches (62) de connexion, qui y sont disposées, en solidifiant ainsi le matériau de la pluralité de couches (62) de connexion,
dans lequel, pour au moins l'un de la pluralité de substrats (10), s'applique ce qui suit :
aucun intercalaire n'est disposé en dessous d'une première moitié du substrat (10) respectif et un ou plusieurs intercalaires (824) sont disposés en dessous d'une deuxième moitié du substrat (10) respectif,
dans lequel la première moitié et la deuxième moitié du substrat (10) respectif, sont définies par un plan (A), qui s'étend dans la direction (y) verticale et divise le substrat (10) en deux moitiés essentiellement semblables, et
dans lequel chacun du un ou des plusieurs intercalaires (824) est noyé dans le matériau de la couche (62) de connexion respective.

9. Le procédé de la revendication 8, dans lequel,
avant de chauffer la plaque (80) de base avec la pluralité de substrats (10) et de couches (62) de connexion, qui y sont disposées, la plaque (80) de base a une déflexion convexe, et
pendant le stade de refroidissement de la plaque (80) de base avec la pluralité de substrats (10) et de couches (62) de connexion, qui y sont disposées, la plaque (80) de base se déforme de sa forme convexe à une forme plane.
